Europäisches Patentamt

European Patent Office

Office européen des brevets

(19)

(11) Numéro de publication: **0 160 587**

**B1**

(12) **FASCICULE DE BREVET EUROPEEN**

(45) Date de publication du fascicule du brevet: **26.10.88**

(51) Int. Cl.⁴: **H 03 J 7/14, H 01 P 1/218**

(21) Numéro de dépôt: **85400490.0**

(22) Date de dépôt: **14.03.85**

(54) Dispositif de contrôle de la fréquence d'un filtre à résonance gyromagnétique.

(30) Priorité: **19.03.84 FR 8404199**

(43) Date de publication de la demande:
**06.11.85 Bulletin 85/45**

(45) Mention de la délivrance du brevet:
**26.10.88 Bulletin 88/43**

(84) Etats contractants désignés:
**AT BE CH DE FR GB IT LI NL SE**

(56) Documents cités:
**FR-A-2 177 033**
**FR-A-2 343 360**
**GB-A-1 492 862**
**US-A-4 153 849**
**US-A-4 243 949**
**TELECOMMUNICATIONS AND RADIO ENGINEERING, vol. 35/36, no. 6, juin 1981, pages 72-76, Scripta Publishing Co., Silver Spring, US; V.P. GOLOLOBOV et al.: "Magnetically tuned semiconductor microwave devices"**
**FUNKSCHAU, no. 24, novembre 1980, pages 66-68, Munich, DE; M. ARNOLD: "Yig-Komponenten Prinzip, Aufbau und Eisatz. 2. Teil"**

(73) Titulaire: **ENERTEC**
**12 Place des Etats Unis**
**F-92120 Montrouge (FR)**

(72) Inventeur: **Marcoux, Jean**
**2 Allée Watteau**
**F-78180 Montigny Le Bretoneux (FR)**
Inventeur: **Barratt, Christopher**
**20, rue d'Arceuil**
**F-75014 Paris (FR)**

(74) Mandataire: **Bentz, Jean-Paul**
**SCHLUMBERGER INDUSTRIES Propriété Intellectuelle Groupe Electricité B.P. 620-02**
**F-92542 Montrouge Cédex (FR)**

Courier Press, Leamington Spa, England.

EP 0 160 587 B1

## Description

La présente invention concerne un dispositif de contrôle de la fréquence de travail, associée à un champ magnétique de travail, d'un filtre à résonance gyromagnétique, en fonction d'une fréquence de référence à laquelle correspond, au moins de façon théorique, un champ magnétique de référence, comme connu par exemple par le document GB-A-1492 862.

Les filtres à résonance gyromagnétique utilisent des résonateurs monocristallins, par exemple de ferrite YIG ou GaYIG (grenat yttrium-fer ou grenat yttrium-fer-gallium), ou de ferrite de lithium, ou de baryum, placés dans le champ magnétique continu d'un électro-aimant.

Le réglage de l'intensité de ce champ magnétique permet de régler la fréquence de travail du filtre, qui fonctionne en passe-bande. En raison de leur correspondance biunivoque dans la théorie de la résonnance gyromagnétique, les notions de fréquence d'un signal et d'intensité d'un champ magnétique peuvent d'ailleurs être substituées l'une à l'autre aussi longtemps que les phénomènes concernés sont ceux de la résonance gyromagnétique.

Dans les filtres à résonateurs gyromagnétiques, un signal d'entrée hyperfréquence (RF) appliqué à l'une des extrémités d'une boucle d'entrée, dont l'autre extrémité est à la masse, excite le résonateur.

Le signal de sortie RF filtré est récupéré sur une boucle de sortie du filtre, analogue à la boucle d'entrée mais disposée dans un plan perpendiculaire à celui qui contient la boucle d'entrée.

Ce filtres bien connus permettent de sélectionner des signaux dans une bande de frequence qui peut être considérée comme relativement etroite par rapport à la fréquence des signaux sélectionnés.

Lorsque de tels filtres sont utilisés avec d'autres organes, tels que des oscillateurs, dans des appareils complexes, tels que des analyseurs de spectres, il est nécessaire que les fréquences de travail des organes combinés satisfassent à des relations bien définies.

Par exemple, la fréquence centrale de travail d'un filtre, et la fréquence d'oscillation d'un oscillateur local bombiné à cè filtre dans un analyseur de spectre, doivent pouvoir être modifiées ensemble tout en gardant un écart de fréquence constant.

Cette contrainte est la source de difficultés d'autant plus importantes que l'écart de fréquence à garder constant est faible par rapport à la fréquence de travail du filtre, que l'intensité du champ magnétique de travail du filtre n'est pas connue directement, mais seulement par la relation théorique qui la lie à l'intensité du courant alimentant l'électro-aimant que crée ce champ magnétique, et que différents facteurs, principalement la température, sont responsables d'un certain décalage entre la fréquence de résonance réelle du filtre et la fréquence de résonance théorique telle que la prévoit la relation théorique qui la lie au champ magnétique appliqué.

Dans ce contexte, le but de la présente invention est d'écarter les difficultés précédemment mentionnées en proposant un dispositif de contrôle de la fréquence de travail d'une filtre à résonance gyromagnétique qui n'agisse pas seulement en fonction de la valeur du courant d'alimentation de l'electro-aimant du filtre, ni même en fonction de la valeur du champ magnétique créé par cet electroaimant, mais directement en fonction de cette fréquence de trvaail.

Le dispositif de l'invention est essentiellement caractérisé en ce qu'il comprend un discriminateur de fréquence physiquement intégré au filtre et soumis aux influences régnant dans ce dernier, ce discriminateur comportant des premier et second résonateurs gyromagnétiques soumis non seulement au champ magnétique de travail du filtre mais en outre à des premier et second champs magnétiques locaux supplémentaires respectifs formant, avec le champ magnétique de travail du filtre, des premier et second champs magnétiques résultants, dont les intensités sont respectivement supérieure et inférieure à celle du champ magnétique de référence, et en ce que ces résonateurs sont tous deux excités par un signal électromagnétique à la fréquence de référence, de manière à produire, sur des sorties respectives, des signaux de sortie respectifs dépendant chacun de l'amplitude et/ou du signe du déséquilibre entre le champ magnétique résultant auquel est soumis le résonateur concerné et le champ magnétique de référence correspondant au signal à la fréquence de référence que reçoit ce résonateur, ce dispositif comportant des organes d'asservissement recevant ces deux signaux de sortie et agissant sur l'intensité du champ magnétique de travail du filtre, dans un sens propre à réduire l'amplitude et/ou changer le signe du déséquilibre affectant le résonateur présentant le déséquilibre le plus grand.

Dans le cas ou la fréquence de travail du filtre doit présenter par rapport à la fréquence de référence un décalage non nul, la demi-somme des premier et second champs magnétiques locaux supplémentaires est fixée à une valeur non nulle, correspondant au décalage désiré entre la fréquence de travail du filtre et la fréquence de référence.

Dans un mode de réalisation simple, les organes d'asservissement comprennent ·des premier et second détecteurs reliés aux sorties respectives des premier et second résonateurs, et délivrant des signaux de sortie respectifs, représantatifs desdits déséquilibres, et sensiblement continus.

Les sorties des premier et second détecteurs sont par exemple reliées aux entrées d'un amplificateur différentiel délivrant un signal d'erreur dont la polarité et l'amplitude sont respectivement représentatives du signe et de l'amplitude de l'écart entre la valeur de la fréquence réelle de travail du filtre et la valeur qu'elle devrait avoir en fonction de la valeur de la fréquence de référence.

De préférence, la ligne conduisant ledit signal à la fréquence de référence jusqu'aux premier et second résonateurs est commune à ces deux résonateurs.

Dans le cas ou la fréquence de travail du filtre est décalée par rapport à la fréquence de référence, les deux champs magnétiques locaux supplémentaires sont de préférence formés par la superposition d'un champ magnétique commun uniforme pour les deux résonateurs, et de deux champs respectifs de même intensité et de sens contraires, créés par une boucle de courant croisée.

L'invention est applicable aux analyseurs de spectres, dans lesquels le fonctionnement du filtre est lié à celui d'un oscillateur local. Plus généralement, l'invention est applicable aux récepteurs hyperfréquence à large bande et à tous les systèmes utilisant un filtre à résonance gyromagnétique dont la fréquence de travail doit être réglée en fonction d'une fréquence de référence. Dans la plupart des cas envisageables, le signal à la fréquence de référence utilisé est le signal de sortie d'un oscillateur local.

D'autres caractéristiques et avantages de l'invention ressortiront de la description qui en est faite ci-après, à titre indicatif et nullement limitatif, en référence au dessin annexé dans lequel:

— la figure 1 est une vue d'ensemble du dispositif, sur laquelle les moyens de production des champs magnétiques locaux ont été omis pour des raisons de clarté.

— la figure 2 est une vue schématique représentant les moyens de production des champs magnétiques locaux, et

— la figure 3 est un diagramme représentant l'amplitude D de la différence des signaux de sortie des détecteurs en fonction de l'écart entre le champ magnétique moyen total auquel est soumis le discriminateur et le champ magnétique correspondant à la fréquence de référence.

La présente invention concerne les filtres passe-bande du type filtre YIG ou GaYIG, et le contrôle de leur fréquence de travail.

Ces filtres comprennant, de façon connue, au moins un, et par exemple trois résonateurs de ferrite $Y_1$, $Y_2$, $Y_3$, soumis d'une part à un champ magnétique continu réglable H et d'autre part au rayonnement électromagnétique d'un signal d'entrée hyperfréquence RF circulant dans une boucle d'entrée BE1, BE2, BE3, entourant au moins partiellement le resonateur et disposée dans un plan parallèle au champ magnétique H.

Pour chaque résonateur est prévue une boucle de sortie BS1, BS2, BS3, analogue à la boucle d'entrée mais perpendiculaire à celle-ci.

Chaque résonateur induit dans la boucle de sortie qui lui est associée un signal de sortie RF se situant dans une bande dont la fréquence centrale est réglée par l'intensité du champ H et dont l'amplitude dépend de l'amplitude du spectre de fréquence du signal d'entrée RF dans cette bande.

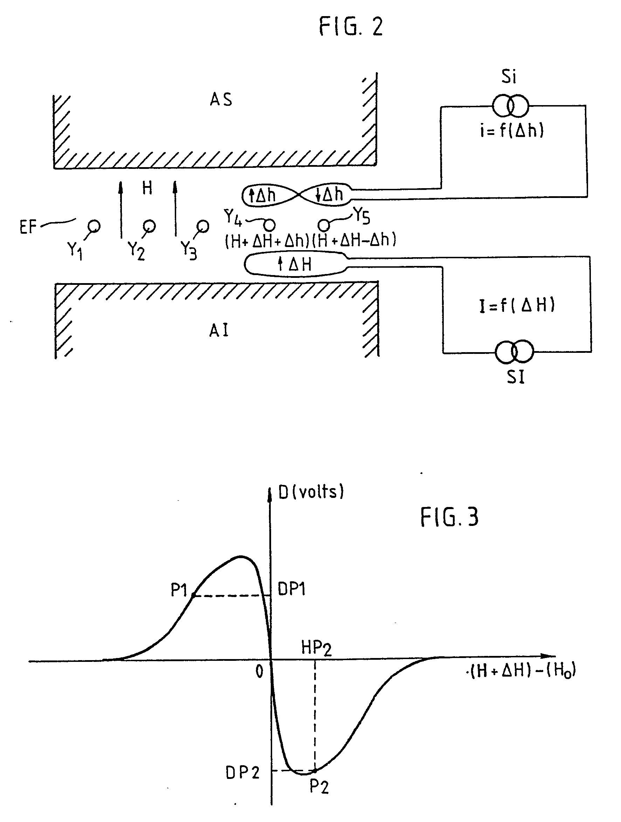

Les résonateurs sont maintenus par des barreaux de matériau amagnétique (non représentés) dans l'entrefer EF (fig. 2) d'un électro-aimant composé d'un pôle inférieur A1 et d'un pôle supérieur AS. Le champ H est contrôlé en fonction due courant électrique $I_c$ alimentant cet électro-aimant.

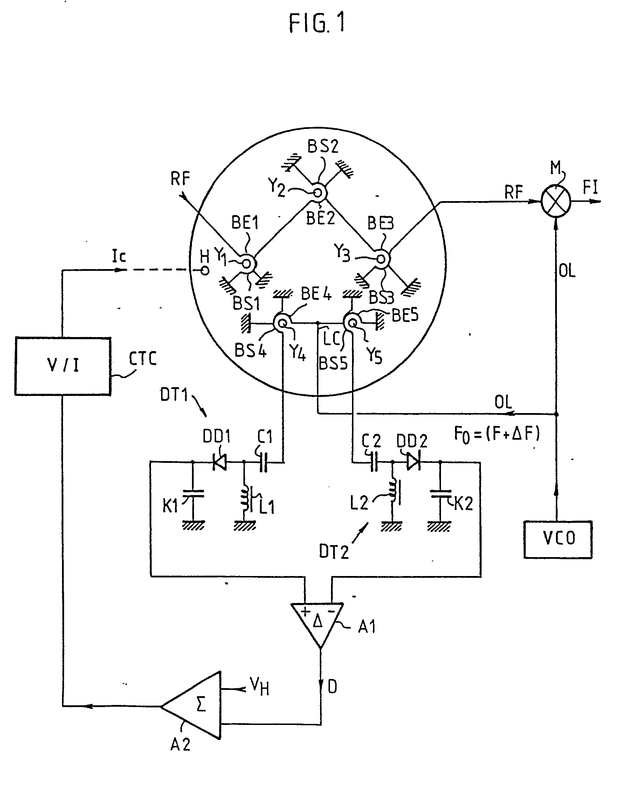

Les figures 1 et 2 représentent un filtre à trois résonateurs en cascade. Le signal de sortie des deux premiers résonateurs $Y_1$, $Y_2$ constitue le signal d'entrée des résonateurs respectifs suivants $Y_2$, $Y_3$, et comme le montre la figure 1, une extrémité de chaque boucle BE1 à BE3 et BS1 à BS3 est reliée à la masse.

Le signal de sortie RF du filtre est par exemple mélangé, dans un mélangeur M, au signal de sortie OL d'un oscillateur local, par exemple un oscillateur VCO commandé en tension, en vue de produire un signal à fréquence intermédiaire FI.

Par exemple, le fréquence du signal RF filtré peut être de l'ordre de quelques gigaherz à une vingtaine de gigaherz, et la fréquence du signal FI, qui est égale à la différence entre la fréquence du signal filtré RF et celle du signal de référence OL, peut être d l'ordre de quelques centaines de mégaherz.

Le dispositif de l'invention a pour fonction d'ajuster à une valeur désirée, par rapport à la fréquence du singal de référence OL, la fréquence de travail du filtre.

A cette fin, ce dispositif comprend essentiellement: deux résonateurs gyromagnétiques $Y_4$, $Y_5$ faisant partie d'un discriminateur de fréquence; deux détecteurs DT1, DT2 respectivement reliés aux boucles de sorties BS4, BS5 des résonateurs $Y_4$, $Y_5$; un amplificateur différentiel A1 recevant les signaux de sortie des détecteurs; un amplificateur sommateur A2 réalisant la somme algébrique du signal de sortie de l'amplificateur différentiel et d'une tension de réglage $V_H$; et un convertiseur tension-courant CTC alimenté par l'amplificateur sommateur A2 et produisant le courant d'alimentation $1_c$ de l'électro-aimant du filtre.

Les résonateurs $Y_4$, $Y_5$ reçoivent sur leurs boucles d'entrée respectives BE4, BE5, le signal d'oscillateur local OL, pris comme référence de fréquence.

Ces résonateurs $Y_4$, $Y_5$ sont, comme les résonateurs du filtre, disposés dans l'entrefer de l'electro-aimant du filtre et sont donc soumis au champ magnétique de travail H du filtre, ainsi qu'à toutes les influences auxquelles sont également soumis les résonateurs $Y_1$, $Y_2$, $Y_3$.

Cependant, comme le montre la figure 2, les résonateurs $Y_4$, $Y_5$ du discriminateur de fréquence sont en outre soumis à des champs magnétiques locaux supplémentaires, d'intensités respectives $\triangle H + \triangle h$ et $\triangle H - \triangle h$, formant, avec le champ de travail H du filtre, des champs résultants respectifs d'intensités $H + \triangle H + \triangle h$ et $H + \triangle H - \triangle h$.

Les champs locaux supplémentaires $\triangle H + \triangle h$ et $\triangle H - \triangle h$ sont formés par la superposition d'un champ magnétique $\triangle H$ commun aux deux résonateurs et de deux champs magnétiques $\triangle h$ et $- \triangle h$ de même intensité mais de sens contraire.

Le champ local commun $\triangle H$ est produit par une boucle de courant, à une ou plusieurs spires, disposée dans l'entrefer EF de l'électro-aimant du filtre à proximité des résonateurs $Y_4$, $Y_5$, et alimentée par une source de courant continu SI délivrant un courant d'intensité I.

Les champs locaux contraires $\triangle h$ et $- \triangle h$ sont produits par une boucle de courant croisée, à une ou plusieurs spires, également disposée dans l'entrefer EF de l'électro-aimant à proximité des résonateurs.

La boucle de courant est croisée entre les deux résonateurs, et alimentée par une source de courant continue $S_1$ délivrant un courant d'intensité 1.

Les champs $\triangle H$ et $\triangle h$ ont des valeurs relativement faibles et correspondent par exemple respectivement à des fréquences de quelques centaines et de quelques dizaines de mégaherz. En raison de ces faibles valeurs, la correspondance théorique entre l'intensité des champs locaux supplémentaires $\triangle H + \triangle h$ et $\triangle H - \triangle h$ et les décalages de fréquence de résonance $\triangle F + \triangle f$ et $\triangle F - \triangle f$ qu'ils introduisent pour les résonateurs $Y_4$ et $Y_5$ est supposée vérifiée.

La moyenne arithmétique (ou demi-somme) $\triangle H$ des intensités des champs locaux supplémentaires est ajustée pour correspondre au décalage de fréquence $\triangle F$ qu'on désire introduire entre la fréquence de référence $Fo = F + \triangle F$, qui est la fréquence du signal OL de l'oscillateur VCO, et la fréquence F de travail du filtre.

Le fonctionnement du dispositif est le suivant:

Imaginons que le champ magnétique de travail H du filtre soit trop faible par rapport à la valeur qu'il devrait avoir pour que la fréquence de travail F du filtre soit bien égale à la fréquence de référence Fo diminuée du décalage $\triangle F$.

Ceci signifie que le champ résultant moyen $H + \triangle H$ est trop faible pour correspondre à la fréquence Fo.

En conséquence, le résonateur $Y_4$, qui est soumis à un champ résultant $H + \triangle H + \triangle h$, dans lequel le champ supplémentaire local $\triangle h$ compense partiellement ou totalement la faiblesse du champ H, transmet sur sa boucle de sortie BS4 plus d'énergie que n'en transmet, sur la boucle BS5, le résonateur $Y_5$ qui est soumis à un champ résultant $H + \triangle H - \triangle h$, plus faible encore que le champ $H + \triangle H$.

Les détecteurs DT1 et DT2, dont la fonction n'est essentiellement que de transformer en signaux continus les signaux de sortie des résonateurs $Y_4$ et $Y_5$, délivrent des signaux que sont les images des niveaux de sortie des résonateurs $Y_4$ et $Y_5$.

Ainsi, le niveau de signal de sortie de l'amplificateur différentiel A1, représentatif de la différence entre les signaux de sortie des détecteurs DT1 et DT2 est par exemple représenté par le point P1 de la courbe de la figure 3, dont l'ordonnée est DP1.

Un signal de DP1 volts est donc ajouté, dans le sommateur A2, à la tension de consigne $V_H$ qui s'est avérée insuffisante pour assurer au filtre une fréquence de travail $F = Fo - \triangle F$.

Le convertisseur tension courant CTC, qui produit par exemple un courant augmentant avec la tension de commande qu'il reçoit, est commandé par une tension $V_H + DP1$, et produit donc un courant corrigé $I_c$ d'intensité plus grande que s'il était commandé par la seule tension $V_H$. Le champ magnétique H est ainsi corrigé de manière à rapprocher le point $P_1$ du point origine 0.

Si, au contraire, le champ H avait été trop fort, correspondant à une erreur de champ magnétique égale à l'abscisse HP2 du point $P_2$ de la figure 3, le signal de sortie du détecteur DT2 aurait eu un niveau supérieur à celui du signal de sortie du dàtecteur DT1. L'amplificateur différentiel A1 aurait ainsi délivré un signal négatif d'amplitude DP2 et la tension de commande du convertisseur CTC aurait diminué, entraînant une diminution de l'erreur affectant l'intensité du champ magnétique H.

Les détecteurs DT1, DT2, l'amplificateur différentiel A1, l'amplificateur sommateur A2 et le convertisseur CTC réalisent ainsi un asservissement du champ magnétique H dans un sens propre à réduire la différence entre le champ moyen $H + \triangle H$ auquel sont soumis les résonateurs $Y_4$, $Y_5$, et le champ $H_o$ correspondant à la fréquence de référence Fo du signal OL pris comme référence.

Les détecteurs DT1, DT2 sont par exemple des détecteurs connus comportant chacun une capacité d'entrée C1, C2, en série avec une diode de sortie DD1, DD2, le point commun à la capacité d'entrée et à la diode de sortie étant relié à la masse à travers une inductance L1, L2, et la borne de sortie du détecteur étant elle-même reliée à la masse à travers une seconde capacité K1, K2.

De préférence, comme le montre la figure 1, le signal de référence OL est appliqué directement, par une ligne commune LC, sur les boucles d'entrée BE4 et BE5 des résonateurs $Y_4$, $Y_5$.

Par rapport à une solution qui utiliserait un couplage de lignes, l'emploi d'une ligne commune présente le double avantage de conduire à une réalisation plus simple et de permettre une conversation de l'énergie apportée par le signal de référence OL. Ainsi, celui des résonateurs $Y_4$, $Y_5$ dont la fréquence de résonance est le plus compatible avec la fréquence du signal qu'il reçoit bénéficie de l'énergie excédentaire que l'autre résonateur reçoit sans pouvoir la transmettre à sa sortie, en raison du couplage plus faible que cet autre résonateur réalise entre son entrée et sa sortie.

## Revendications

1. Dispositif de contrôle de la fréquence de travail (F), associée à un champ magnétique de travail (H), d'un filtre à résonance gyromagnétique ($Y_1$, $Y_2$, $Y_3$) en fonction d'une fréquence de référence (Fo) à laquelle correspond, au moins de façon théorique, un champ magnétique de référence (Ho), caractérisé en ce qu'il comprend un discriminateur de fréquence ($Y_4$, $Y_5$, DT1, DT2, A1) physiquement intégré au filtre et soumis aux influences régnant dans ce dernier, ce discriminateur comportant des premier et second résonateurs gyromagnétiques ($Y_4$, $Y_5$) soumis non seulement au champ magnétique de travail du filtre,

mais en outre à des premier et second champs magnétiques locaux supplémentaires ($\triangle H + \triangle h$, $\triangle H - \triangle h$) respectifs formant, avec le champ magnétique de travail du filtre (H), des premier et second champs magnétique résultants, dont les intensités sont respectivement supérieure et inférieure à celle du champ magnétique de référence, et en ce que ces résonateurs sont tous deux excités par un signal électromagnétique (OL) à la fréquence de référence (Fo) de manière à produire, sur des sorties respectives, des signaux de sortie respectifs dépendant chacun de l'amplitude et/ou du signe du déséquilibre entre le champ magnétique résultant auquel est soumis le résonateur concerné, et le champ magnétique de référence correspondant au signal à la fréquence de référence que reçoit ce résonateur, ce dispositif comportant des organes d'asservissement (DT1, DT2, A1, A2, CTC) recevant ces deux signaux de sortie et agissant sur l'intensité du champ magnétique de travail (H) du filtre dans un sens propre à réduire l'amplitude et/ou changer le signe du déséquilibre affectant le résonateur présentant le déséquilibre le plus grand.

2. Dispositif suivant la revendication 1, caractérisé en ce que la demi-somme des premier et second champs magnétiques locaux supplémentaires ($\triangle H + \triangle h$, $\triangle H - \triangle h$) est fixée à une valeur non nulle, correspondant à un décalage ($\triangle F$) désiré entre la fréquence de travail du filtre (F) et la fréquence de référence (Fo).

3. Dispositif suivant la revendication 1 ou 2, caractérisé en ce que lesdits organes d'asservissement comprennent des premier et second détecteurs (DT1, DT2) reliés aux sorties respectives des premier et second résonateurs ($Y_4$, $Y_5$), et délivrant des signaux de sortie respectifs, représentatifs desdits déséquilibres, et sensiblement continus.

4. Dispositif suivant la revendication 3, caractérisé en ce que les sorties des premier et second détecteurs (DT1, DT2) sont reliées aux entrées d'un amplificateur différentiel (A1) délivrant un signal d'erreur dont la polarité et l'amplitude sont respectivement représentatives du signe et de l'amplitude de l'écart entre la valeur de la fréquence réelle de travail du filture et la valeur qu'elle devrait avoir en fonction de la valeur de la fréquence de référence.

5. Dispositif suivant l'une quelconque des revendications précédentes, caractérisé en ce que la ligne (LC) conduisant ledit signal (OL) à la fréquence de référence jusqu'aux premier et second résonateurs ($Y_4$, $Y_5$) est commune à ces deux résonateurs.

Dispositif suivant l'une quelconque des revendications précédentes combinée à la revendication 2, caractérisé en ce que les deux champs magnétiques locaux supplémentaires ($\triangle H + \triangle h$, $\triangle H - \triangle h$) sont formés par la superposition d'un champ magnétique commun ($\triangle H$) uniforme pour les deux résonateurs, et de deux champs respectifs de même intensité ($\triangle h$) et de sens contraires, créés par une boucle de courant croisée.

7. Dispositif suivant l'une quelconque des revendications précédentes, caractérisé en ce que ledit signal à la fréquence de référence (Fo) est le signal de sortie d'un oscillateur local (VCO) auquel le filtre est fonctionnellement lié.

8. Application du dispositif selon la revendication 7 à l'adaptation en fréquence d'un filtre et d'un oscillateur dans un analyseur de spectre.

**Patentansprüche**

1. Steueranordnung für die einem magnetischen Arbeitsfeld (H) zugeordneten Arbeitsfrequenz (F) eines gyromagnetischen Resonanzfilters ($Y_1$, $Y_2$, $Y_3$) in Abhängigkeit von einer Referenzfrequenz (FO), der zumindest theoretisch ein magnetisches Referenzfeld (HO) entspricht, dadurch gekennzeichnet, daß sie einen Frequenzdiskriminator ($Y_4$, $Y_5$, DT1, DT2, A1) umfaßt, der physisch in dem Filter integriert ist und den in diesem herrschenden Einflüssen ausgesetzt ist, welcher Diskriminator erste und zweite gyromagnetische Resonatoren ($Y_4$, $Y_5$) umfaßt, die nicht nur dem magnetischen Arbeitsfeld des Filters ausgesetzt sind, sondern darüber hinaus ersten und zweiten lokalen zusätzlichen Magnetfeldern ($\triangle H + \triangle h$, $\triangle H - \triangle h$), die jeweils mit dem magnetischen Arbeitsfeld des Filters (H) erste bzw. zweite resultierende Magnetfelder bilden, deren Intensitäten größer bzw. kleiner sind als diejenige des Referenzmagnetfeldes, und daß diese Resonatoren beide durch ein elektromagnetisches Signal (OL) mit der Referenzfrequenz ($F_o$) derart erregt sind, daß sie auf zugeordneten Ausgängen Ausgangs-signale erzeugen, die jeweils jedes von der Amplitude und/oder dem Vorzeichen des Ungleichgewichts zwischen dem resultierenden Magnetfeld, dem der betreffende Resonator unterworfen ist un dem Referenzmagnetfeld entsprechend dem Signal mit der Referenzfrequenz abhängen, das der Resonator empfängt, welche Anordnung Regelorgane (DT1, DT2, A1, A2, CTC) umfaßt, welche diese beiden Ausgangssignale empfangen und auf die Intensität des Arbeitsmagnetfeldes (H) des Filters in einem Sinne einwirken, daß die Amplitude verringert wird und/oder das Vorzeichen des Ungleichgewichts verringert wird, das den das größte Ungleichgewicht aufweisenden Resonator beeinflußt.

2. Anordnung nach Anspruch 1, dadurch gekennzeichnet, daß die Halbsumme der ersten und zweiten lokalen zusätzlichen Magnetfelder ($\triangle H + \triangle h$, $\triangle H - \triangle h$) festliegt bei einem von Null abweichenden Wert entsprechend einem gewünschten Versatz ($\triangle F$) zwischen der Arbeitsfrequenz des Filters (F) und der Referenzfrequenz ($F_o$).

3. Anordnung nach Anspruch 1 oder 2, dadurch gekennzeichnet, daß die genannten Regelorgane erste und zweite Detektoren (DT1, DT2) umfassen, verbunden mit den jeweiligen Ausgängen des ersten bzw. zweiten Resonators ($Y_4$, $Y_5$) und entsprechende Ausgangssignale liefern, die repräsentativ sind für die genannten Ungleichgewichte und im wesentlichen kontinuierlich.

4. Anordnung nach Anspruch 3, dadurch gekennzeichnet, daß die Ausgänge des ersten und des zweiten Detektors (DT1, DT2) mit Eingängen eines Differenzialverstärkers (A1) verbunden sind, der ein Fehlersignal liefert, dessen Polarität und Amplitude repräsentativ sind für das Vorzeichen bzw. die Amplitude des Versatzes zwischen dem Wert der realen Arbeitsfrequenz des Filters und dem Wert, den sie haben müßte in Funktion des Wertes der Referenzfrequenz.

5. Anordnung nach einem der vorangehenden Ansprüche, dadurch gekennzeichnet, daß die das genannte Referenzfrequenzsignal (OL) führende Leitung bis zu dem ersten und dem zweiten Resonator ($Y_4$, $Y_5$) diesen beiden Resonatoren gemeinsam ist.

6. Anordnung nach einem der vorangehenden Ansprüche in Kombination mit Anspruch 2, dadurch gekennzeichnet, daß die beiden zusätzlichen lokalen Magnetfelder ($\triangle H + \triangle h$, $\triangle H - \triangle h$) gebildet werden durch die Überlagerung eines gleichförmigen, den beiden Resonatoren gemeinsamen Magnetfeldes ($\triangle H$) und zweier Magnetfelder gleicher Intensität ($\triangle h$) und entgegengesetzter Richtung, erzeugt durch eine sich kreuzende Stromschleife.

7. Anordnung nach einem der vorangehenden Ansprüche, dadurch gekennzeichnet, daß das genannte Referenzfrequenzsignal ($F_0$) das Ausgangssignal eines lokalen Oszillators (VCO) ist, mit dem das Filter in Funktionsverbindung steht.

8. Anwendung der Anordnung nach Anspruch 7 auf die Frequenzadaptation eines Filters und eines Oszillators in einem Spektrumanalysator.

**Claims**

1. Apparatus for control of the operating frequency (F), associated with an operating magnetic field (H), of a gyromagnetic resonance filter ($Y_1$, $Y_2$, $Y_3$), as a function of a reference frequency (FO) to which corresponds, theoretically at least, a reference magnetic field (HO), characterised in that it includes a frequency discriminator ($Y_4$, $Y_5$, $\triangle$T1, A1) physically integrated with the filter and subject to the conditions prevailing in the latter, the discriminator having first and second gyromagnetic resonators ($Y_4$, $Y_5$) subject not only to the operating magnetic field of the filter, but also to supplementary first and second local magnetic fields ($\triangle H + \triangle h$, $\triangle H - \triangle h$) forming respectively, with the operating magnetic field of the filter (H), first and second resultant magnetic fields, the intensities of which are respectively greater and less than that of the reference magnetic field, and in that the resonators are both excited by an electromagnetic signal ($\triangle L$) at the reference frequency (FO) so as to provide, at respective outputs, output signals respectively dependent each on the amplitude and/or sign of the imbalance between the resultant magnetic field to which the resonator concerned is subject, and the reference magnetic field corresponding to the reference frequency signal that said resonator receives, the apparatus including control elements ($\triangle$T1, $\triangle$T2, A1, A2, CTC) receiving the two output signals and acting on the intensity of the operating magnetic field (H) of the filter in a sense so as to reduce the amplitude and/or change the direction of the imbalance affecting the resonator having the greater imbalance.

2. Apparatus in accordance with claim 1, characterised in that the semi-sum of the first and second supplementary local magnetic fields ($\triangle H + \triangle h$, $\triangle H - \triangle h$) is fixed at a non-zero value, corresponding to desired offset ($\triangle F$) between the operating frequency of the filter (F) and the reference frequency (FO).

3. Apparatus in accordance with claim 1 or 2, characterised in that said control elements include first and second detectors ($\triangle$T1, $\triangle$T2) connected to the respective outputs of the first and second resonators ($Y_4$, $Y_5$) and providing respective output signals, representing said imbalances, and substantially continuous.

4. Apparatus in accordance with claim 3 characterised in that the outputs of the first and second detectors ($\triangle$T1, $\triangle$T2) are connected to inputs of a differential amplifier (A1) providing an error signal, the polarity and the amplitude of which are respectively representative of the sign and amplitude of the difference between the actual value of operating frequency of the filter and the value which it ought to have as a function of reference frequency value.

5. Apparatus in accordance with any preceding claim, characterised in that the path (LC) connecting said reference frequency signal (OL) to the first and second resonators ($Y_4$, $Y_5$) is common to both resonators.

6. Apparatus in accordance with any preceding claim in combination with claim 2, characterised in that the two supplementary local magnetic fields ($\triangle H + h$, $\triangle H - h$) are formed by the superposition of a common magnetic field ($\triangle H$) uniform for the two resonators, and two respective fields of the same intensity ($\triangle h$) and opposite sense, provided by a crossed current loop.

7. Apparatus in accordance with any preceding claim, characterised in that said reference frequency signal (FO) is the output signal of a local oscillator (VCO) to which the filter is functionally tied.

8. Use of apparatus in accordance with claim 7 to frequency control of a filter of an oscillator in a spectrum analyser.

## FIG.1

FIG. 2

FIG. 3